# EUROPEAN PATENT APPLICATION

(11) **EP 2 727 687 A1**
(43) Date of publication of application: **07.05.2014**
(21) Application number: 13162194.8
(22) Date of filing: 03.04.2013
(51) Int. Cl.: B25H 1/06, H05K 5/02

(54) **Accommodation rack configured to sustain a housing**

(30) Priority: 05.11.2012 TW 101221363 U
(71) Applicant: Compal Broadband Networks Inc., 114 Taipei City (TW)
(72) Inventor: Chiu, Chih-Hsin, 302 Hsinchu County (TW)
(74) Representative: Becker Kurig Straus

(57) **Abstract**

An accommodation rack (10) configured to sustain a housing (1) includes a first body (100) having a first end (1000) and a second end (1002) connected to the housing (1), wherein an internal surface (1012) of the first body (100) is attached to a bottom surface (12) of the housing (1), and a second body (102) having a third end (1020) and a fourth end (1022) connected to the housing (1), wherein an internal surface (1032) of the second body (102) is attached to the bottom surface (12) of the housing (1). The first body (100) and the second body (102) are disposed onto the bottom surface (12) of the housing (1) to be accommodated as the accommodation rack (10), or the first body (100) and the second body (102) are rotated away from the bottom surface (12) with a predetermined angle to sustain the housing (1).

## Description

### Field of the Invention

The application relates to an accommodation rack configured to sustain a housing, and more particularly, to an accommodation rack which sustains a housing or is easily accommodated when not being utilized for sustentation according to the pre-characterizing clauses of claim 1.

### Background of the Invention

As the technology advances, network communication devices have been rapidly developed to provide fast and convenient Internet services. People find it difficult to live or work without the Internet, such that telecommunication suppliers have provided proper modems corresponding to different Internet services for users to connect with the Local Area Network (LAN) or the Wide Area Network (WAN). Different environmental conditions as well as accommodation spaces are important issues while concerning industrial designs of the modem. One way is to design the modem with a bigger bottom area for straightly standing-up, but less flexible design space remains. Another way is to provide related accessories as supporting racks to be fixedly locked onto any surfaces of the modem. However, it is possible to lose related accessories before installation for the careless users, or it is difficult to unlock/replace the related accessories of the supporting racks after being fixedly locked onto the housing, so as to result in more restriction for utilizing the modem. Additionally, if the product manufacturers directly install the related accessories of supporting racks onto the housing before delivery, unnecessary cost accompanying a larger modem size of the increases inevitably.

Therefore, it is necessary to provide another accommodation rack which sustains a housing or is conveniently accommodated when not being utilized for sustentation.

### Summary of the Invention

This in mind, the application aims at providing an accommodation rack to solve the abovementioned problems.

This is achieved by an accommodation rack according to claim 1. The dependent claims pertain to corresponding further developments and improvements.

As will be seen more clearly from the detailed description following below, the claimed accommodation rack includes a first body having a first end and a second end both coupled to the housing, and an internal surface of the first body is attached to a bottom surface of the housing; and a second body having a third end and a fourth end both coupled to the housing, and an internal surface of the second body is attached to the bottom surface of the housing. The first body and the second body are disposed onto the bottom surface of the housing to obtain an accommodated form, or the first body and the second body are away from the bottom surface of the housing with a predetermined angle to sustain the housing.

### Brief Description of the Drawings

In the following, the invention is further illustrated by way of example, taking reference to the accompanying drawings. Thereof
FIG. 1 illustrates a schematic diagram of a housing being accommodated when not utilized for sustentation according to an embodiment of the present invention,
FIG. 2 illustrates a schematic diagram of the housing being utilized for sustentation according to an embodiment of the present invention,
FIG. 3 illustrates a side schematic diagram of the housing according to an embodiment of the present invention,
FIG. 4 illustrates a schematic diagram of a first body according to an embodiment of the present invention,
FIG. 5 illustrates a schematic diagram of a second body according to an embodiment of the present invention,
FIG. 6 and FIG. 7 illustrate schematic diagrams of a single magnified side of the first body according to an embodiment of the present invention, and
FIG. 8 illustrates a local schematic diagram of the first body according to an embodiment of the present invention.

### Detailed Description

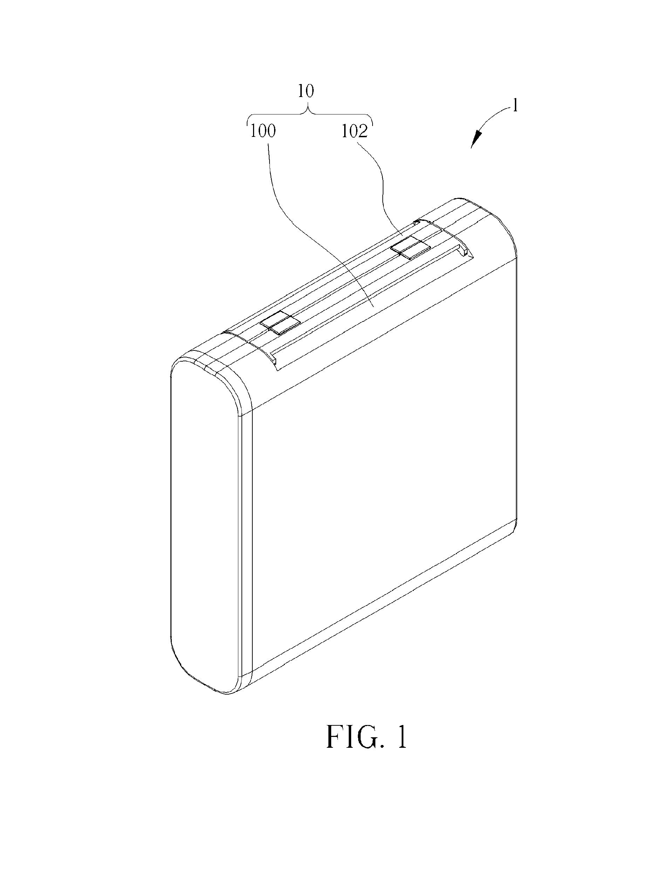

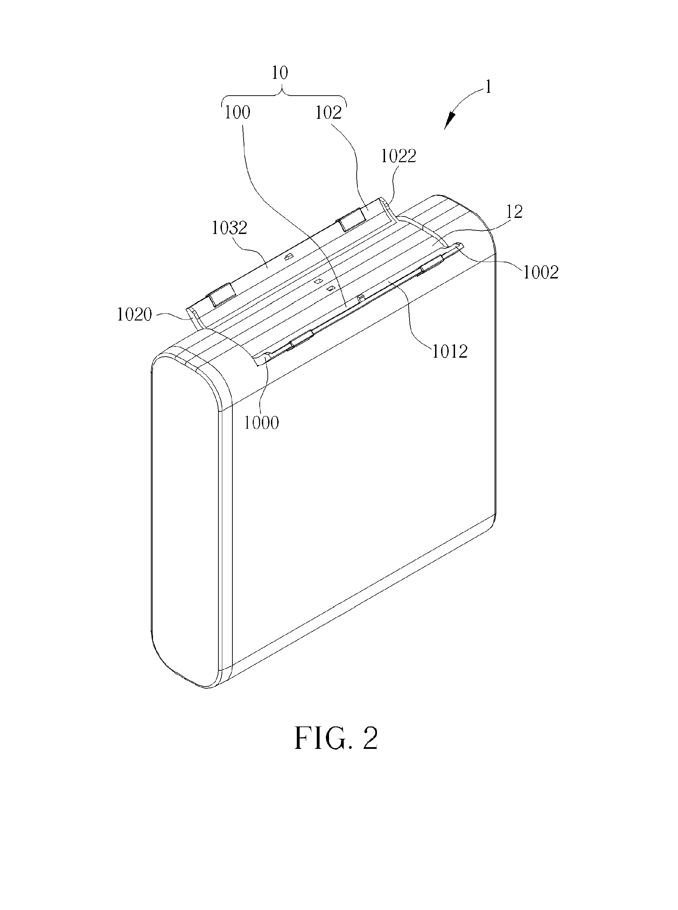

Please refer to FIG. 1 and FIG. 2, wherein FIG. 1 illustrates a schematic diagram of a housing 1 being accommodated when not utilized for sustentation according to an embodiment of the present invention, and FIG. 2 illustrates a schematic diagram of the housing 1 being utilized for sustentation according to an embodiment of the present invention. As shown in FIG. 1 and FIG. 2, the housing 1 is a modem in the embodiment and comprises an accommodation rack 10. The housing 1 can be implemented as a computer system or a product required for sustentation according to different practical requirements. The accommodation rack 10 comprises a first body 100 and a second body 102, and both are symmetrically disposed onto a bottom surface 12 of the hosing 1. Materials of the first body 100 and the second body 102 can be the same as those of the housing 1 for saving costs, such as a resin material, a high molecular polymer or a thermoplasticity material.

In the embodiment, the first body 100 and the second body 102 are obtained as long-arm structures, and disposition ways as well as external structures thereof can be symmetrical or asymmetrical as long as the first body 100 and the second body 102 can be flatly disposed onto the housing 1 as a whole or are rotated away from the bottom surface 12 of the housing 1. When a user tries to process an accommodation operation, he/she can follow the embodiment shown in FIG. 1 to dispose the accommodation rack 10 related to the housing 1, such that the first body 100 and the second body 102 are closely attached to the bottom surface 12 of the housing 1 via internal surfaces 1012, 1032 thereof. Accordingly, the user will be able to easily and conveniently move the housing 1 with such a reduced external size of the housing 1.

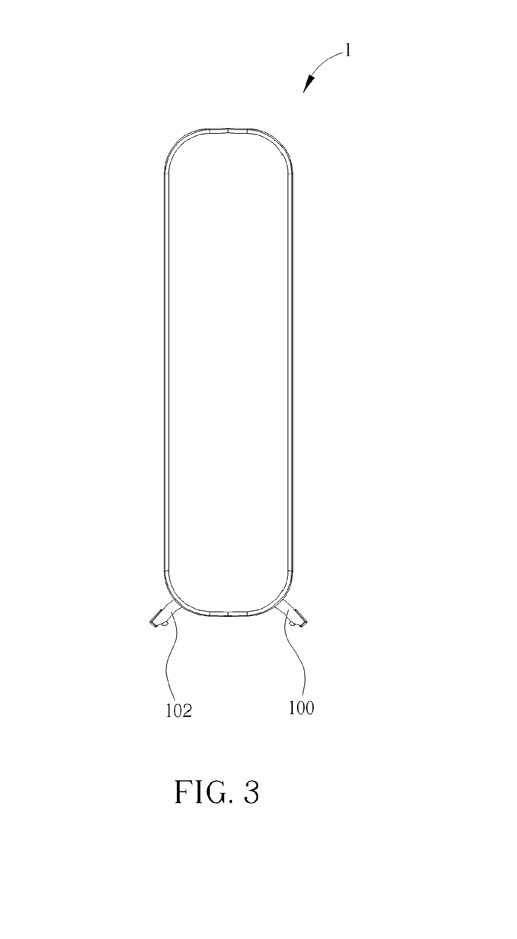

Moreover, when the user tries to process a disposition operation, the first body 100 and the second body 102 of the accommodation rack 10 are opened with a predetermined angle according to the embodiment shown in FIG. 2, such that the first body 100 and the second body 102 are rotated away from the bottom surface 12 of the housing 1 for sustaining the housing 1 in a stand-up position (or a accommodation form). Please refer to FIG. 3, which illustrates a side schematic diagram of the housing 1 according to an embodiment of the present invention. As shown in FIG. 3, the first body 100 and the second body 102 of the present invention can be designed to comply with different environmental conditions as well as accommodation spaces, such that the first body 100 and the second body 102 of the present invention are not necessary to be symmetrically disposed or to be opened with the same predetermined angle as long as the housing 1 can stably stand up.

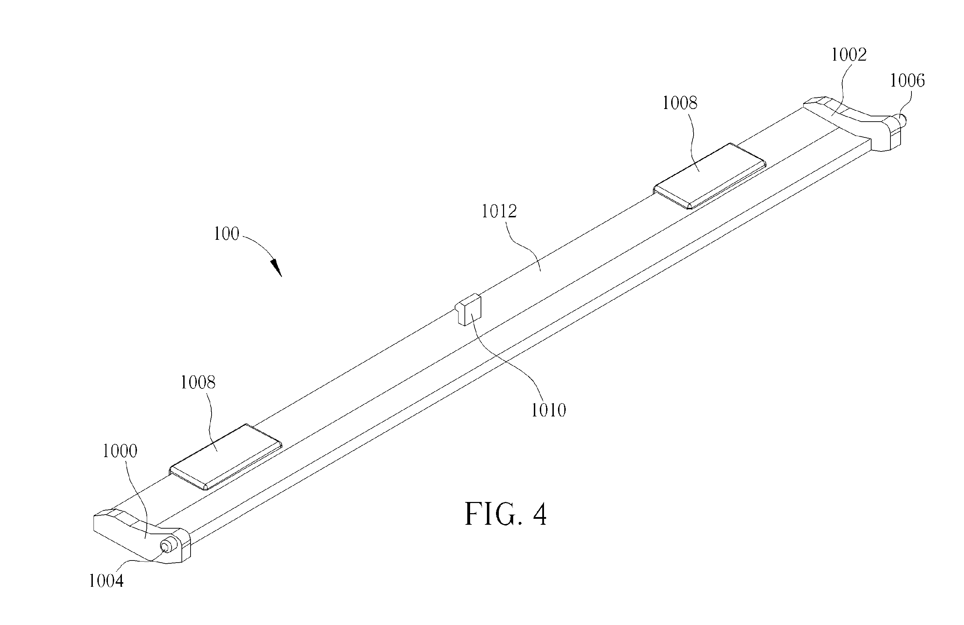

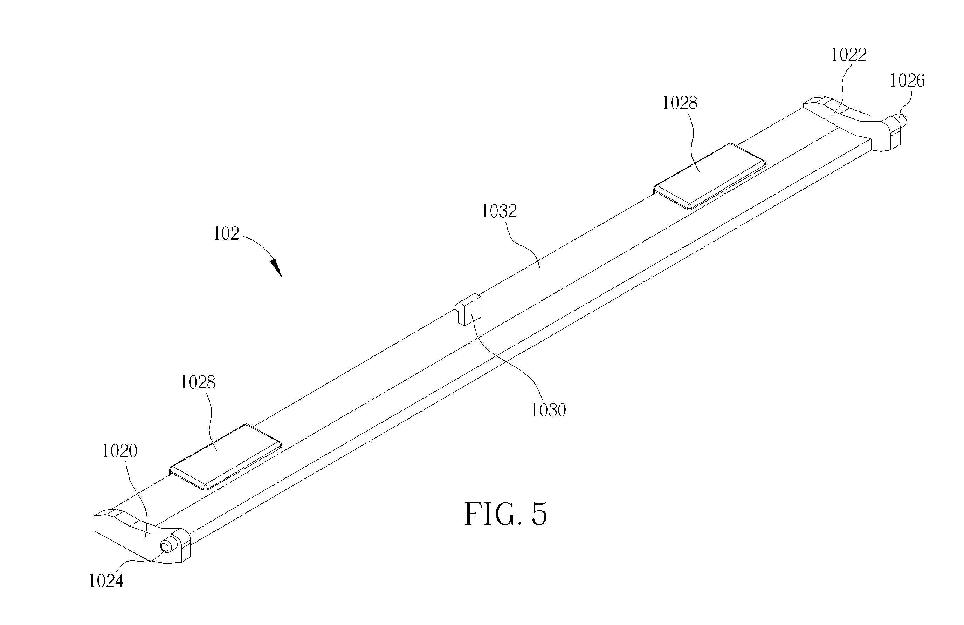

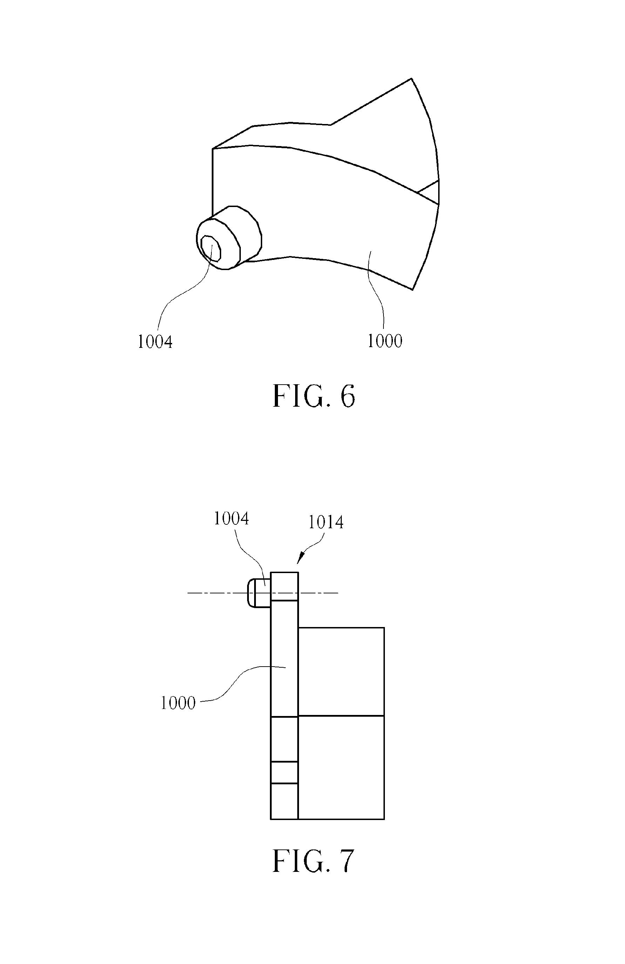

Please refer to FIG. 4 and FIG. 5, wherein FIG. 4 illustrates a schematic diagram of a first body 100 according to an embodiment of the present invention and FIG. 5 illustrates a schematic diagram of a second body 102 according to an embodiment of the present invention. Since the first body 100 is similar to the second body 102, only the first body 100 is described herein for brevity. As shown in FIG. 4, two sides 1000, 1002 of the first body 100 are utilized to be fixed onto the bottom surface 12 of the housing 1, and each of the two sides 1000, 1002 comprises connecting units 1004, 1006 formed as column units. In the meanwhile, equivalent number/size of cavities corresponding to the connecting units 1004, 1006 can also be disposed on the housing 1, such that the first body 1 can utilize the connecting units 1004, 1006 to be attached/inserted into the cavities of the housing 1. Please refer to FIG. 6 and FIG. 7, which illustrate schematic diagrams of a single magnified side of the first body 100 according to an embodiment of the present invention. As shown in FIG. 6 and FIG. 7, the side 1000 and the connecting unit 1004 are connected together via a cantilever structure 1014, such that a virtual extension line connecting the connecting units 1004, 1006 can be regarded as a rotational axis to make the first body 100 (or the second body 102) be rotated to arbitrary angles. In the embodiment, materials of the cantilever structure and the first body 100 (or the second body 102) share flexible and elastic characteristics, such that the cavities of the housing 1 and the connecting units 1004, 1006 of the first body 100 (or the second body 102) can be compressed together to form a fixed connection relationship.

Please refer to FIG. 4 again. The first body 100 further comprises a plurality of skidproof pads 1008 (or a plurality of skidproof pads 1028 of the second body 102) to increase a friction effect for the first body 100 (or the second body 102) sustaining the housing 1. In the embodiment, the number of the plurality of skidproof pads 1008, 1028 is two. During production, the plurality of skidproof pads 1008, 1028 can be formed as rubber materials, and more particularly, the first body 100 (or the second body 102) and the plurality of skidproof pads 1008, 1028 are obtained via a two-component injection molding process.

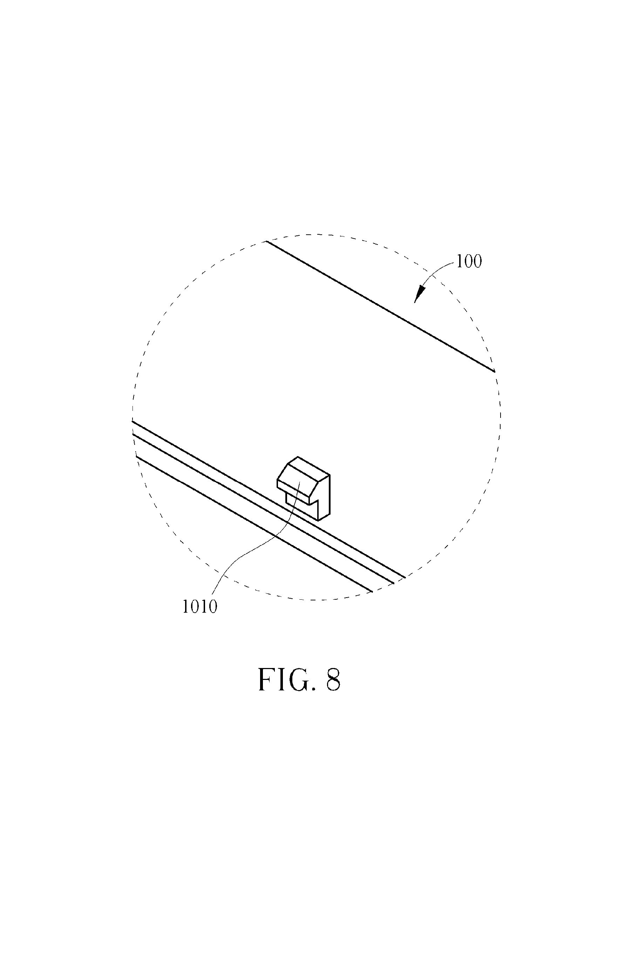

Please refer to FIG. 8, which illustrates a local schematic diagram of the first body 100 according to an embodiment of the present invention. As shown in FIG. 4 and FIG. 8, the first body 100 further comprises a snap unit 1010 disposed onto a central position surface of the first body 100 (or a snap unit 1030 of the second body 102). In the meanwhile, the housing 1 can be disposed with the equivalent number/size of cavities, such that the first body 100 (or the second body 102) can utilize not only the connecting units 1004, 1006 to be accommodated/attached onto the bottom surface 12 of the housing 1 but also the snap units 1010, 1030 to be fixedly attached/inserted into the cavities of the housing 1, so as to enhance an attachment relationship between the first body 100 (or the second body 102) and the housing 1.

Noticeably, the invention can further utilize a linkage unit (not shown in the figure) to connect the first body 100 and the second body 102 for moving together. Thus, while switching between the disposition operation and the sustention operation, the user only has to rotate/move one of the first body 100 and the second body 102 to obtain the related movements by the other one of the first body 100 and the second body 102 due to the linkage unit. The first body 100 and the second body 102 can also alternatively be disposed onto any plane/surface of the housing 1 other than the bottom surface, such that those skilled in the art can share the similar concept of the present invention to make the first body 100 and the second body 102 be hanged on/relied on the housing 1 for simultaneously providing the disposition operation and the sustention operation.

To sum up, the present invention provides an accommodation rack with flexible designs for convenient accommodation on a housing, such as a modem, as well as suitable sustention. In comparison with the prior art, no more related accessories are needed in the present invention, and situations as having difficultly unlocking the related accessories can be avoided as well. Additionally, the entire size of the housing can be effectively reduced for saving delivery costs. Thus, the accommodation rack of the present invention can be adaptively switched between the disposition operation and the sustention operation, and more economic benefits thereof can be anticipated while dealing with various living conditions.

## Claims

1. An accommodation rack (10) configured to sustain a housing (1),
**characterized by**
a first body (100) comprising a first end (1000) and a second end (1002) both coupled to the housing (1), and an internal surface (1012) of the first body (100) is attached to a bottom surface (12) of the housing (1); and
a second body (102) comprising a third end (1020) and a fourth end (1022) both coupled to the housing (1), and an internal surface (1022) of the second body (102) is attached to the bottom surface (12) of the housing (1);
wherein the first body (100) and the second body (102) are disposed onto the bottom surface (12) of the housing (1) to obtain an accommodated form, or the first body (100) and the second body (102) are away from the bottom surface (12) of the housing (1) with a predetermined angle to sustain the housing (1).

2. The accommodation rack of claim 1, **characterized in that** the first end (1000) and the second end (1002) each comprise a plurality of connecting units (1004, 1006) coupled to the housing (1), such that the first body (100) utilizes the plurality of the connecting units (1004, 1006) as a rotational axis such that the first body (100) is rotatable away from the bottom surface (12) of the housing (1).

3. The accommodation rack of claim 1, **characterized in that** the third end (1020) and the fourth end (1022) each comprise a plurality of connecting units (1024, 1026) coupled to the housing (1), such that the second body (102) utilizes the plurality of the connecting units (1024, 1026) as a rotational axis such that the second body (102) is rotatable away from the bottom surface (12) of the housing (1).

4. The accommodation rack of claim 2 or claim 3, **characterized in that** each connecting unit (1004, 1006, 1024, 1026) further comprises a cantilever structure (1014) coupled to the first body (100) or the second body (102), and is obtained as a column unit to be fixedly compressed on the housing (1).

5. The accommodation rack of claim 1, **characterized in that** the first body (100) and the second body (102) further comprise a snap unit (1010, 1030), such that the first body (100) and the second body (102) are fixed onto the bottom surface (12) of the housing (1).

6. The accommodation rack of claim 1, **characterized in that** the first body (100) and the second body (102) further comprise a plurality of skidproof pads (1008, 1028) to increase a friction effect for the first body (100) and the second body (102) sustaining the housing (1).

7. The accommodation rack of claim 6, **characterized in that** the plurality of skidproof pads (1008, 1028) are attached to the internal surface (1012, 1032) of the first body (100) and the second body (102), such that the first body (100) and the second body (102) are away from the bottom surface (12) of the housing (1) via the predetermined angle to touch a ground.

8. The accommodation rack of claim 6, **characterized in that** the plurality of skidproof pads (1008) are obtained via a two-component injection molding process forming onto the first body (100) and the second body (102).

9. The accommodation rack of claim 1, **characterized in that** the housing (1) is a modem.
